# EUROPEAN PATENT SPECIFICATION

(11) **EP 0 415 530 B1**
(45) Date of publication and mention of the grant of the patent: **30.11.1994**
(21) Application number: 90307353.4
(22) Date of filing: 05.07.1990
(51) Int. Cl.: H01L 27/108

(54) **Semiconductor memory device having stacked capacitor and method of producing the same**
Halbleiterspeicheranordnung mit Stapelkondensator und Verfahren zu ihrer Herstellung
Dispositif de mémoire semi-conducteur à capacités empilées et méthode de fabrication

(30) Priority: 05.07.1989 JP 171827/89
(43) Date of publication of application: 06.03.1991
(73) Proprietor: FUJITSU LIMITED, Kawasaki-shi, Kanagawa 211 (JP)
(72) Inventor: Gotou, Hiroshi, Niiza-shi, Saitama 352 (JP)
(74) Representative: Fane, Christopher Robin King

(56) References cited:
- EP-A- 0 295 709
- DE-A- 3 910 033
- US-A- 4 700 457
- PATENT ABSTRACTS OF JAPAN, vol. 12, no. 281 (E-641)[3128], 2nd August 1988;& JP-A-63 058 958
- IDEM
- IDEM
- PATENT ABSTRACTS OF JAPAN, vol. 14, no. 229 (E-928)[4172], 15th May 1990;& JP-A-2 060 162
- PATENT ABSTRACTS OF JAPAN, vol. 14, no. 36 (E-877), 23rd January 1990;& JP-A-1 270 343
- PATENT ABSTRACTS OF JAPAN, vol. 14, no. 168 (E-912)[4111], 30th March 1990;& JP-A-2 023 657
- PATENT ABSTRACTS OF JAPAN, vol. 12, no. 469 (E-691)[3316], 8th December 1988;& JP-A-63 188 966
- PATENT ABSTRACTS OF JAPAN, vol. 12, no. 498 (E-698)[3345], 26th December 1988;& JP-A-63 208 263

## Description

The present invention generally relates to semiconductor memory devices and methods of producing semiconductor memory devices, and more particularly to a semiconductor memory device which has a fin type stacked capacitor which is used as a charge storage capacitor and a method of producing such a semiconductor memory device.

Presently, a stacked capacitor or a trench capacitor is often used as a charge storage capacitor of a dynamic random access memory (DRAM).

Such charge storage capacitors occupy a relatively small area on a substrate but can realize a relatively large capacitance. Hence, it is expected that such charge storage capacitors can improve the integration density and the signal-to-noise (S/N) ratio of the DRAM at the same time. However, further improvements of such charge storage capacitors are still required.

Compared to the trench capacitor, the production of the stacked capacitor is simple. In addition, the reproducibility of the stacked capacitor is better compared to that of the trench capacitor.

Recently, a DRAM having the so-called fin type stacked capacitor is proposed in Ema et al., "3-Dimensional Stacked Capacitor Cell For 16M and 64M DRAMs", International Electron Devices Meeting, pp.592-595, December 1988. The fin type stacked capacitor includes electrodes and dielectric films which extend in a fin shape in a plurality of stacked layers.

Such a DRAM device is also disclosed, for example, in EP-A-0295709 and may be considered to include: a transfer transistor having first and second active regions constituting respectively source and drain regions of the transistor, which regions are formed in a substrate of the device at a main surface of the substrate; an insulator layer formed on the said main surface; a first conductive layer contacting one of the said active regions, so as to be electrically connected therewith, through a contact hole formed in the said insulator layer, and extending outwardly beyond the periphery of the contact hole so as to overlap the said insulator layer adjacent to the hole; at least one further conductive layer located above the said first conductive layer, and extending generally parallel thereto, to form a stack in which the conductive layers are spaced apart one from the next and connected electrically together to form a first electrode structure of a charge storage capacitor of the device; and conductive material provided around the said stack, and within the spaces between the adjacent conductive layers thereof, to form a second electrode structure of the charge storage capacitor, which second electrode structure is separated from the said first electrode structure by a dielectric covering layer on the first electrode structure.

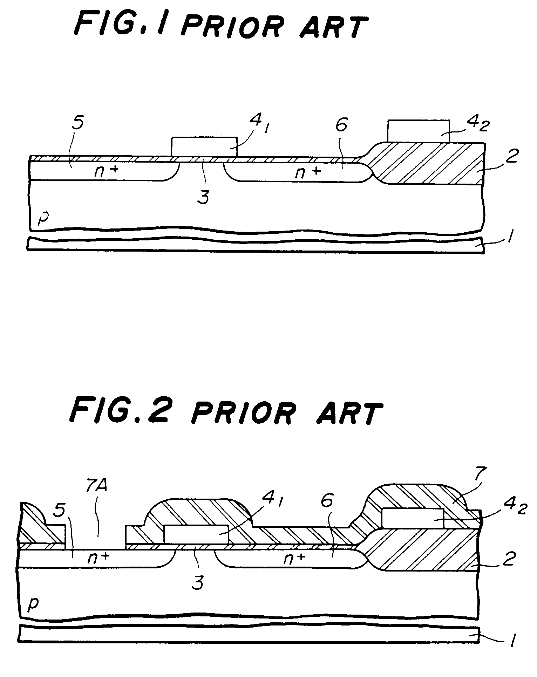

Next, a description will be given of a method of producing such a DRAM having the fin type stacked capacitor, by referring to FIGS.1 through 11.

In FIG.1, a selective thermal oxidation (for example, local oxidation of silicon (LOCOS)) which uses an oxidation resistant mask such as a Si₃N₄ layer is employed to form a field insulator layer 2 on a p-type Si semiconductor substrate 1. The field insulator layer 2 is made of SiO₂ and has a thickness of 3000 Å, for example.

Then, the oxidation resistant mask is removed to expose an active region of the p-type Si semiconductor substrate 1.

A gate insulator layer 3 which is made of SiO₂ and has a thickness of 150 Å, for example, is formed on the substrate surface by a thermal oxidation.

A polysilicon layer having a thickness of 2000 Å, for example, is formed on the gate insulator layer 3 and the field insulator layer 2 by a chemical vapor deposition (CVD).

The polysilicon layer is doped by a p-type impurity by carrying out a thermal diffusion which uses POCl₃ as a source gas.

Next, a resist process of a normal photolithography technique and a reactive ion etching (RIE) using CCl₄+O₂ as an etching gas are used to pattern the polysilicon layer and form gate electrodes 4₁ and 4₂ which correspond to word lines.

The gate electrodes 4₁ and 4₂ are used as a mask and As ions are implanted by an ion implantation. In addition, a thermal process is carried out for activation, so as to form an n⁺-type source region 5 and an n⁺-type drain region 6. The n⁺-type source region 5 corresponds to a bit line contact region, and the n⁺-type drain region 6 corresponds to a storage electrode contact region. For,example, the As ions are implanted with a dosage of 1 x 10¹⁵ cm⁻².

Next, as shown in FIG.2, an interlayer insulator 7 is formed by a CVD. The interlayer insulator 7 is made of SiO₂ and has a thickness of 1000 Å, for example. The interlayer insulator 7 may be made of Si₃N₄.

A resist process of a normal photolithography technique and a RIE using CHF₃+O₂ as an etching gas are carried out to selectively etch the interlayer insulator 7 and form a bit line contact hole 7A.

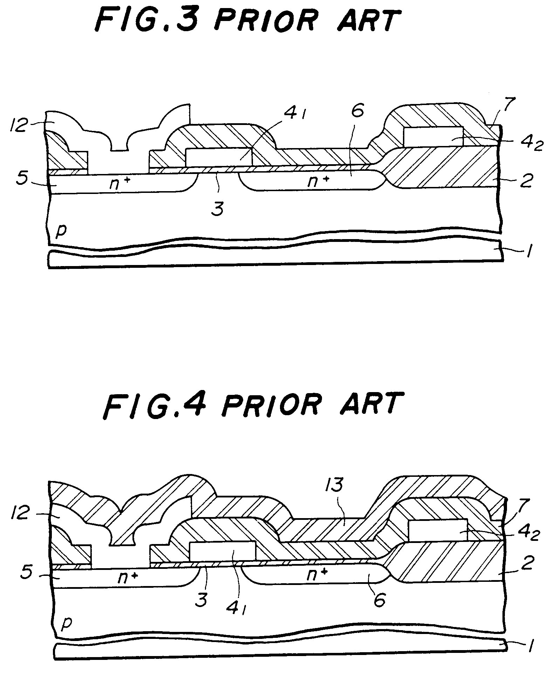

Next, as shown in FIG.3, a CVD is carried out to form a polysilicon layer having a thickness of 500 Å, for example.

In order to make the polysilicon layer conductive, an ion implantation is carried out to implant As ions into the polysilicon layer with a dosage of 1 x 10¹⁷ cm⁻² and an acceleration energy of 50 keV.

A CVD is carried out to form a WSi₂ layer having a thickness of 1000 Å, for example.

A resist process of a normal photolithography technique and a RIE using CCl₄+O₂ as an etching gas are carried out to pattern the polysilicon layer and the WSi₂ layer to form a bit line 12.

Next, as shown in FIG.4, an etching protection layer 13 having a thickness of approximately 1000 Å, for example, is formed by a CVD.

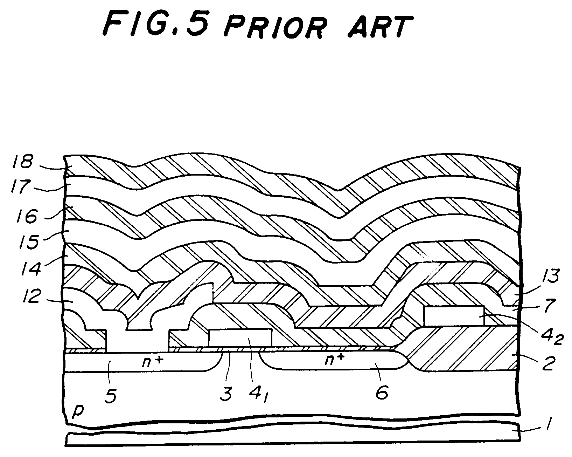

Then, as shown in FIG.5, a SiO₂ layer 14 and a polysilicon layer 15 are formed by a CVD. For example, the SiO₂ layer 14 and the polysilicon layer 15 respectively have a thickness of 1000 Å.

In order to make the polysilicon layer 15 conductive, an ion implantation is carried out to implant As ions with a dosage of 4 x 10¹⁵ cm⁻² and an acceleration energy of 50 keV.

A SiO₂ layer 16 and a polysilicon layer 17 are formed by a CVD. In this case, the SiO₂ layer 16 and the polysilicon layer 17 respectively have a thickness of approximately 1000 Å.

In order to make the polysilicon layer 17 conductive, an ion implantation is carried out to implant As ions with a dosage of 4 x 10¹⁵ cm⁻² and an acceleration energy of 50 keV.

An SiO₂ layer 18 is formed by a CVD. For example, the SiO₂ layer 18 has a thickness of approximately 1000 Å.

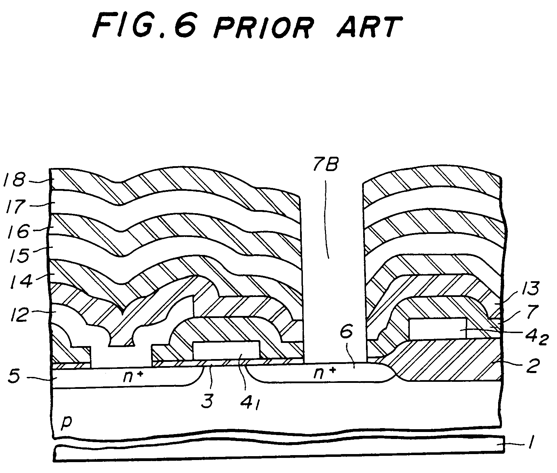

In FIG.6, a resist process of a normal photolithography technique and a RIE are carried out to selectively etch the SiO₂ layer 18 and the like. As a result, a storage electrode contact window 7B is formed. This storage electrode contact window 7B extends from a top surface of the SiO₂ layer 18 to a surface of the n⁺-type drain region 6. The etching gas is desirably CHF₃+O₂ for SiO₂, CCl₄+O₂ for polysilicon, and CHF₃+O₂ for Si₃N₄.

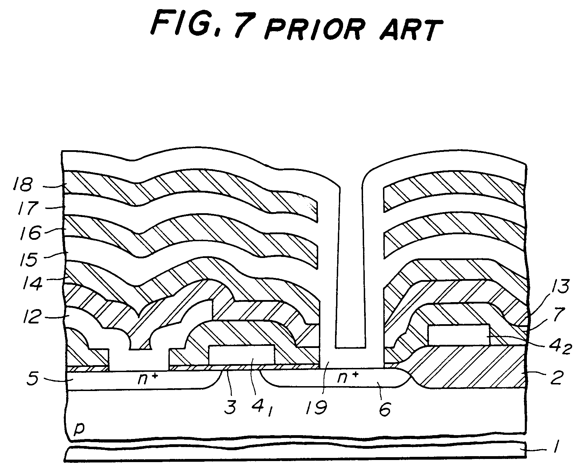

Next, as shown in FIG.7, a polysilicon layer 19 is formed by a CVD. In this case, the thickness of the polysilicon layer 19 is approximately 1000 Å.

In order to make the polysilicon layer 19 conductive, an ion implantation is carried out to implant As ions with a dosage of 4 x 10¹⁵ cm⁻² and an acceleration energy of 50 keV.

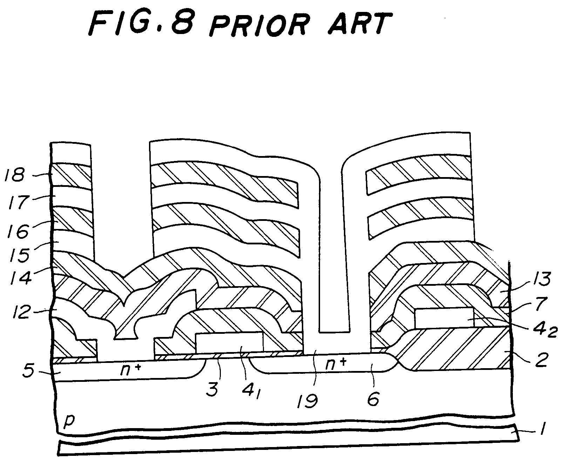

In FIG.8, a resist process of a normal photolithography and RIEs using CCl₄+O₂ as the etching gas for polysilicon and using CHF₃+O₂ as the etching gas for SiO₂ are carried out to pattern the polysilicon layer 19, the SiO₂ layer 18, the polysilicon layer 17, the SiO₂ layer 16 and the polysilicon layer 15 and to form a storage electrode pattern.

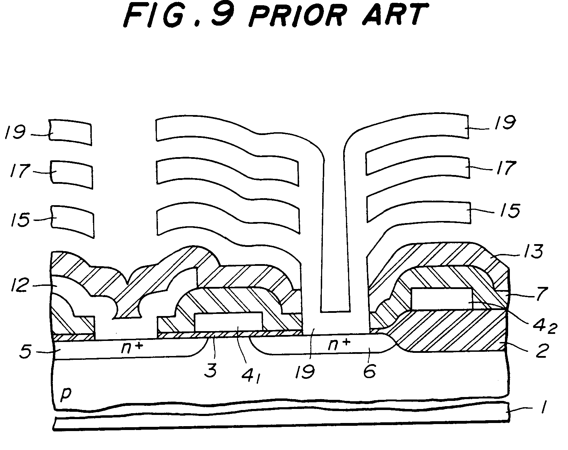

Next, as shown in FIG.9, the structure shown in FIG.8 is submerged into a hydrofluoric acid such as HF:H₂O = 1:10, so as to remove the SiO₂ layers 18, 16 and 14. By carrying out this process, a fin-shaped storage electrode made of polysilicon is formed in a plurality of layers, that is, levels.

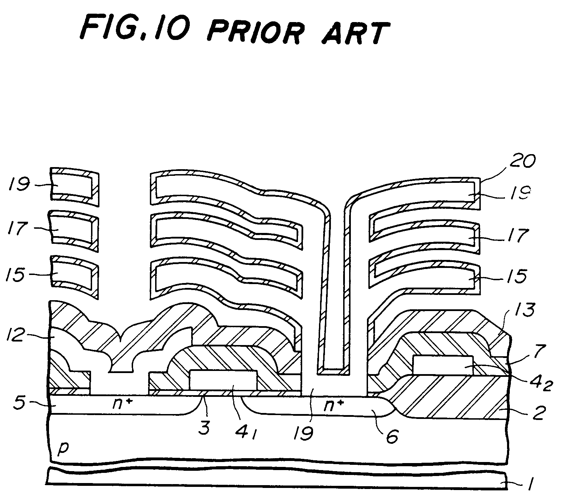

In addition, as shown in FIG.10, a thermal oxidation is carried out to form a dielectric layer 20 having a thickness of 100 Å, for example, on each surface of the polysilicon layers 19, 17 and 15. As an alternative, it is also possible to carry out a CVD in order to form a dielectric layer which is made of Si₃N₄ and has a thickness of 100 Å, for example, on each surface of the polysilicon layers 19, 17 and 15.

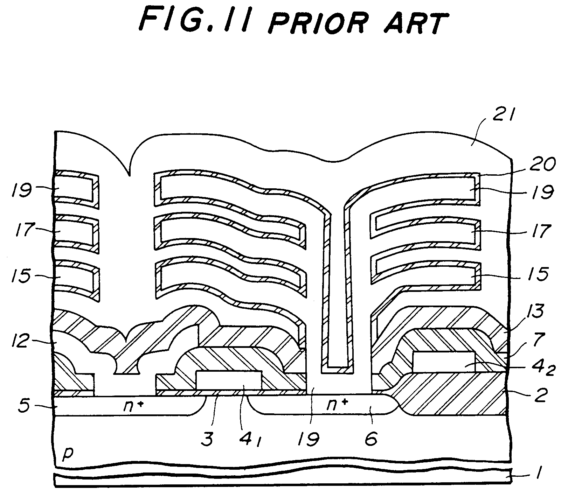

Then, as shown in FIG.11, an opposed electrode (cell plate) 21 which is made of polysilicon and has a thickness of 1000 Å, for example, is formed by a CVD. In addition, the opposed electrode 21 is doped by a p-type impurity by carrying out a thermal diffusion using POCl₃ as a source gas. Further, the opposed electrode 21 is patterned by a RIE using CCl₄+O₂ as an etching gas.

Although not shown in FIG.11, a passivation layer, a bonding pad, an underlayer interconnection for reducing the resistance of the word line, other interconnections and the like are formed to complete the DRAM.

The DRAM which is produced in the above described manner includes a fin type stacked capacitor which has a large capacitance. Hence, even when the size of the fin type stacked capacitor is made extremely small, it is still possible to obtain a sufficiently large information signal and a satisfactory S/N ratio is obtainable. In addition, the resistance against the α-ray is large.

When the fin type stacked capacitor having the above described structure is used to produce a 64 Mbit/chip DRAM, for example, the memory cell becomes extremely fine and various difficulties are encountered.

First, the polysilicon layers 19, 17 and 15 which become the fin-shaped storage electrode of the charge storage capacitor easily disconnect from the polysilicon layer 19 which forms a support part at the core of the capacitor. When the fin-shaped storage electrode disconnects and falls from the support part, the memory cell becomes defective, and in addition, the disconnected fin-shaped storage electrode in most cases act as a foreign particle which damages other memory cells.

Second, when forming the support part (a part of the polysilicon layer 19), the storage electrode contact window 7B which penetrates a plurality of layers is formed. But when forming the storage electrode contact window 7B, the storage electrode contact window 7B must be aligned with respect to the plurality of layers. Such an alignment is extremely difficult to make, and as a result, it is necessary to provide a large alignment margin.

Third, the area occupied by the charge storage capacitor on the substrate is not increased considerably. This is because the support part becomes relatively large compared to the fin-shaped storage electrode as the size of the charge storage capacitor is reduced. Consequently, the rate with which the capacitance is increased by the fin-shaped storage electrode decreases as the size of the charge storage capacitor is reduced.

JP-A-63-58958 discloses a multilayer stacked capacitor of a DRAM device, which is manufactured by stacking alternate conductive and insulating films. In this device, however, the storage electrode has a support part (side wall) which extends straight downwards, along one side of the storage electrode and through a contact hole, to contact the associated active region of the transfer transistor with which the storage electrode is electrically connected. Thus, as in the method described hereinbefore, the formation of the support part appears to be highly demanding from the point of view of alignment and a large alignment margin is accordingly required.

US 4700457 also discloses a multilayer stacked capacitor of a DRAM device which is manufactured by stacking alternate first and second conductive layers, with layers of dielectric material between the adjacent conductive layers, to form a stack which is generally rectangular in plan view. Outer edge regions of the first conductive layers in the stack are etched away on two opposite sides of the stack and similarly outer edge regions of the second conductive layers in the stack are etched away on the other two opposite sides of the stack. In each case insulating material is used to fill the gaps left by etching, and then side walls are formed on all four sides of the stack, so as to contact the unetched edges of the layers and thereby connect all the first conductive layers together and separately connect all the second conductive layers together. In the device concerned, however, the stack is not formed above the active region of the transfer transistor with which it is connected, and the lowermost layer in the stack does not contact that active region directly. Accordingly, the integration density is low. The side walls also do not contribute to the capacitance of the storage capacitor. Furthermore, in the method of fabrication, the side walls are only formed after etching of the layers and do not serve to support the layers during such etching.

In JP-A-63-208263 a high-integration density DRAM device is disclosed in which the storage electrode sits directly on the active region of the transfer transistor with which it is connected, and does not extend outwardly beyond the edges of that active region. In addition, in the fabrication of the device only a single conductive layer is etched, the necessary support for that layer during etching being provided by a support layer formed on, rather than at the side of, the conductive layer.

According to a first aspect of the present invention there is provided a semiconductor memory device including: a transfer transistor having first and second active regions constituting respectively source and drain regions of the transistor, which regions are formed in a substrate of the device at a main surface of the substrate; an insulator layer formed on the said main surface; a first conductive layer contacting one of the said active regions, so as to be electrically connected therewith, through a contact hole formed in the said insulator layer, and extending outwardly beyond the periphery of the contact hole so as to overlap the said insulator layer adjacent to the hole; at least one further conductive layer located above the said first conductive layer, and extending generally parallel thereto, to form a stack in which the conductive layers are spaced apart one from the next and connected electrically together to form a first electrode structure of a charge storage capacitor of the device; and conductive material provided around the said stack, and within the spaces between the adjacent conductive layers thereof, to form a second electrode structure of the charge storage capacitor, which second electrode structure is separated from the said first electrode structure by a dielectric covering layer on the first electrode structure: characterised by a side wall structure made of conductive material and formed alongside the said stack so as to be connected physically to mutually-corresponding respective outer edge regions, remote from the said contact hole, of the conductive layers, so that the said conductive layers together with the said side wall structure constitute the said first electrode structure.

In such a device, the capacitance of the charge storage capacitor is approximately three times that of the conventional fin type charge storage capacitor because the side wall structure functions as a part of the storage electrode (first electrode structure). In addition, the further conductive layer(s) of the storage electrode do(es) not break easily during the production process. Furthermore, the alignment of the charge storage capacitor is simple.

According to a second aspect of the present invention there is provided a method of producing a semiconductor device including a transfer transistor having first and second active regions constituting respectively source and drain regions of the transistor, which regions are formed in a substrate of the device at a main surface of the substrate, and also including a charge storage capacitor having a first electrode structure connected with one of the said active regions and a second electrode structure separated from the said first electrode structure by a dielectric covering layer on the first electrode structure, which method includes the steps of: providing on the said main surface an insulator layer formed with a contact hole through which a part of the said one active region is exposed; forming on the said insulator layer and the exposed part of the said one active region a stack of alternate conductive and spacing layers such that the lowermost layer is a conductive layer, which contacts the said exposed part through the said contact hole and which extends outwardly beyond the periphery of that hole so as to overlap the said insulator layer adjacent to the hole, and such that the layers of the stack have mutually-corresponding respective outer edge regions remote from the said contact hole; forming a side wall structure made of conductive material alongside the said stack so as to be connected physically to the said outer edge regions of the layers of the stack, so that the said conductive layers together with the said side wall structure constitute the said first electrode structure; removing the said spacing layers from the said stack by an etching process, and then forming the said dielectric covering layer on the exposed surface regions of the said conductive layers and of the said side wall structure; and depositing conductive material over the free surfaces of the said dielectric covering layer to form the said second electrode structure.

In such a method, the conductive layers of the storage electrode (first electrode structure) do not break easily during the production process. Furthermore, the alignment of the charge storage capacitor is simple.

In a preferred embodiment the said insulator layer is also formed with a further contact hole through which a part of the other active region is exposed, the insulator layer being provided by forming a gate insulator film on the said substrate above the transfer transistor, forming a word line on the gate insulator film between the said source and drain regions, and forming a first interlayer insulator over the word line, the contact hole which exposes the said one active region and the said further contact hole each passing through the said first interlayer insulator and the gate insulator film; and the alternate conductive and spacing layers are stacked on the said first interlayer insulator and on the respective exposed parts of the two active regions, such that the lowermost of the stacked layers also contacts the said exposed part of the said other active region through the said further contact hole, and then the stacked layers are patterned to form the said stack associated with the said one active region, and a further stack of the layers, separated from the stack associated with the said one active region, above the said further contact hole; the method comprising the further steps of: forming a further side wall structure made of conductive material alongside the said further stack so as to be connected physically to mutually-corresponding respective outer edge regions of the layers of the further stack, so that the said conductive layers of the further stack together with the said further side wall structure constitute a stacked connection structure; providing on the said second electrode structure a second interlayer insulator formed with a contact opening through which an upper part of the said stacked connection structure is exposed; and forming conductive material on the said second interlayer insulator and on the exposed upper part of the further stack, so that the conductive material, which serves as a bit line of the device, is connected electrically to the said other active region of the transfer transistor via the said stacked connection structure.

In such an embodiment, it is possible to prevent the bit line from breaking at the contact opening.

Reference will now be made, by way of example, to the accompanying drawings, in which:
FIGS.1 through 11 are cross sectional views for explaining a method of producing a conventional DRAM having a fin type stacked capacitor;
FIGS.12A through 17A are plan views for explaining a first embodiment of a method of producing a semiconductor memory device according to the present invention for producing a first embodiment of a semiconductor memory device according to the present invention;
FIGS.12B through 17B are cross sectional views respectively along lines X-X in FIGS.12A through 17A for explaining the first embodiment;
FIGS.18A through 20A are plan views for explaining a second embodiment of the method of producing the semiconductor memory device according to the present invention for producing a second embodiment of the semiconductor memory device according to the present invention;
FIGS.18B through 20B are cross sectional views respectively along lines X-X in FIGS.18A through 20A for explaining the second embodiment;
FIGS.21A through 26A are plan views for explaining a third embodiment of the method of producing the semiconductor memory device according to the present invention for producing a third embodiment of the semiconductor memory device according to the present invention;
FIGS.21B through 26B are cross sectional views respectively along lines X-X in FIGS.21A through 26A for explaining the second embodiment;
FIG.27A is a plan view for explaining a fourth embodiment of the semiconductor memory device according to the present invention;
FIG.27B is a cross sectional view along a line X-X in FIG.27A for explaining the fourth embodiment;
FIG.28A is a plan view for explaining a fifth embodiment of the semiconductor memory device according to the present invention; and
FIG.28B is a cross sectional view along a line X-X in FIG.28A for explaining the fifth embodiment.

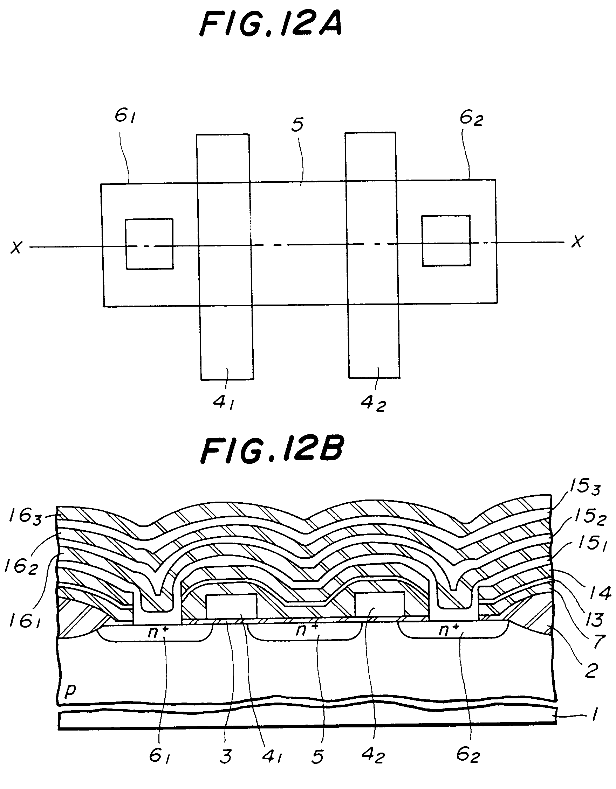

A description will be given of a first embodiment of a semiconductor memory device according to the present invention, by referring to FIGS.12 through 17. This embodiment of the semiconductor memory device is produced by a first embodiment of a method of producing a semiconductor memory device according to the present invention.

In FIGS.12 through 17, FIG.iA shows a plan view of an essential part of the semiconductor memory device and FIG. iB shows a cross section along a line X-X in FIG.iA, where i = 12 to 17. Furthermore, in FIGS.12 through 17, those parts which are essentially the same as those corresponding parts in FIGS.1 through 11 are designated by the same reference numerals.

In this embodiment, an n-channel transistor is used. However, it is of course possible to use a p-channel transistor.

In FIGS.12A and 12B, known techniques are used to form on a p-type Si semiconductor substrate 1 a field insulator layer 2, a gate insulator film 3, gate electrodes (word lines) 4₁ and 4₂ made of polysilicon, an n⁺-type source region (active region) 5, and n⁺-type drain regions (also active regions) 6₁ and 6₂.

CVDs are carried out to form an interlayer insulator 7 which is made of SiO₂ and has a thickness of 3000 Å, for example, an etching protection layer 13 which is made of Si₃N₄ and has a thickness of 500 Å, for example, and a spacer layer 14 which is made of SiO₂ and has a thickness of 2000 Å, for example. The interlayer insulator 7 may be made of Si₃N₄.

The field insulator layer 2, gate insulator film 3 and interlayer insulator 7 together form a combined insulator layer on the substrate, the word lines 4₁ and 4₂ being incorporated in the combined insulator layer.

A resist process of a normal photolithography technique and a RIE using CHF₃+O₂ as an etching gas are carried out to selectively etch the spacer layer 14, the etching protection layer 13, the interlayer insulator 7, the gate insulator film 3 and the like. As a result, storage electrode contact windows are formed above the drain regions 6₁ and 6₂.

CVDs are carried out to successively form a polysilicon layer 15₁ having a thickness of 1000 Å, a SiO₂ layer 16₁ having a thickness of 2000 Å, a polysilicon layer 15₂ having a thickness of 1000 Å, a SiO₂ layer 16₂ having a thickness of 2000 Å, a polysilicon layer 15₃ having a thickness of 1000 Å, and a SiO₂ layer 16₃ having a thickness of 2000 Å.

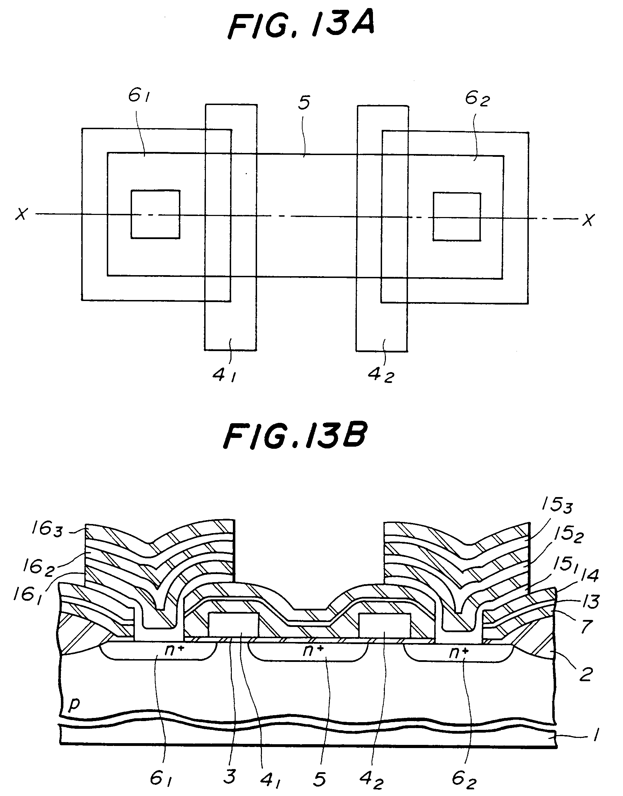

RIEs using CF₄ system etching gas are carried out to pattern the SiO₂ layer 16₃, the polysilicon layer 15₃, the SiO₂ layer 16₂, the polysilicon layer 15₂, the SiO₂ layer 16₁ and the polysilicon layer 15₁ by anisotropic etchings, so as to form a storage electrode pattern shown in FIGS.13A and 13B.

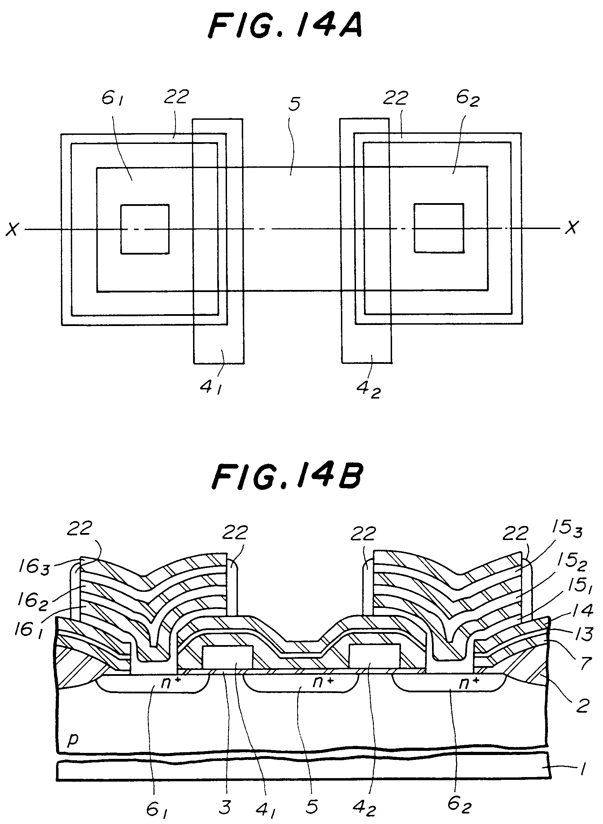

In FIGS.14A and 14B, a CVD is carried out to form a polysilicon layer having a thickness of 2000 Å, for example, on the entire top surface of the structure shown in FIGS.13A and 13B.

A RIE using CCl₄ system etching gas is carried out to pattern the polysilicon layer which is formed in the previous process by an anisotropic etching. As a result, side walls 22, together constituting a side wall structure, made of polysilicon are formed on the sides of the storage electrode pattern. Each side wall 22 supports the polysilicon layers 15₁, 15₂ and 15₃ in and function as a conductive connector.

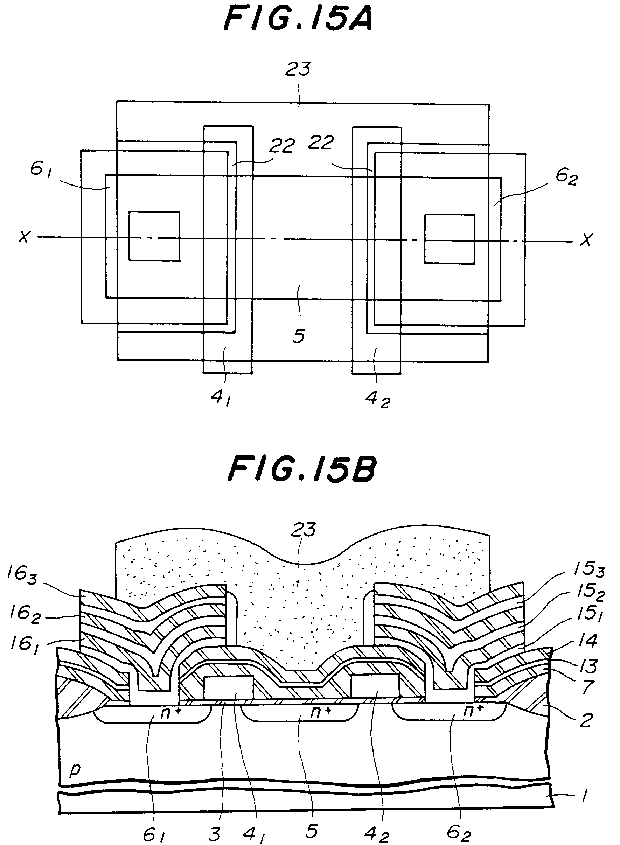

In FIGS.15A and 15B, a resist process of a normal photolithography technique is carried out to form a photoresist layer 23 which covers a large portion of the side walls 22.

A RIE using CF₄ system etching gas is carried out to remove the exposed portions of the side walls 22 by an isotropic etching.

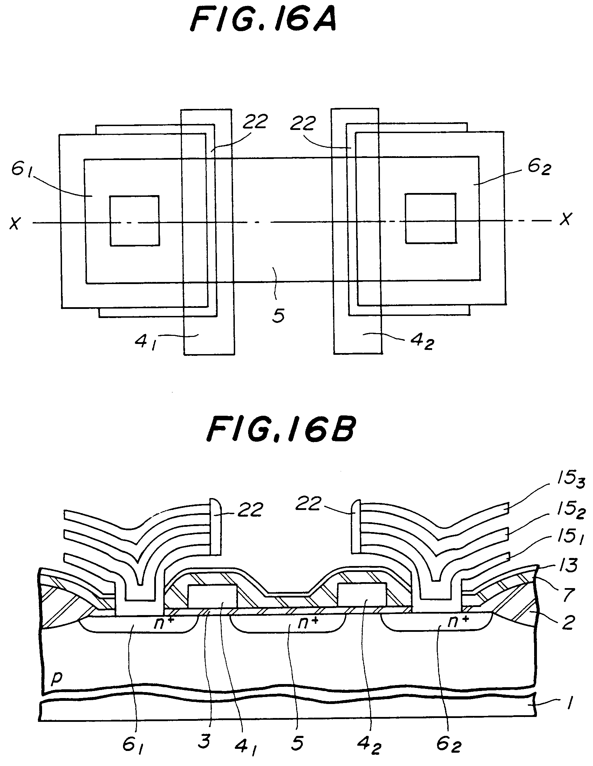

In FIGS.16A and 16B, the photoresist layer 23 is removed before removing the spacer layer 14 by submerging the structure into a hydrofluoric acid etchant. In this case, the etching protection layer 13 made of Si₃N₄ acts as an etching stopper. The SiO₂ layers 16₃, 16₂ and 16₁ are also removed at the same time as the etching of the spacer layer 14.

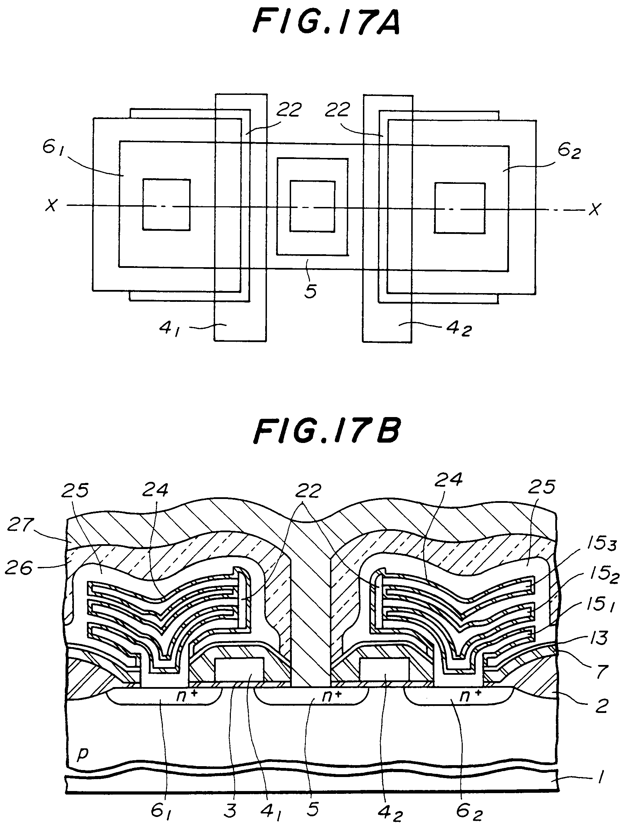

As shown in FIGS.17A and 17B, a thermal oxidation is carried out to form a dielectric layer 24 made of SiO₂ on the exposed portions of the polysilicon layers 15₃, 15₂ and 15₁ made of polysilicon and the side walls 22 made of polysilicon.

Then, a CVD is carried out to form an opposed electrode (cell plate), or seoond electrode structure, 25 which is made of polysilicon and has a thickness of 5000 Å, for example.

A resist process of a normal photolithography technique and a RIE using CCl₃+O₂ as an etching gas are carried out to pattern the opposed electrode 25.

An interlayer insulator 26 which is made of phosphosilicate glass (PSG) and has a thickness of 1 µm, for example, is formed by a CVD.

A normal photolithography technique is used to selectively etch the interlayer insulator 26, the etching protection layer 13, the interlayer insulator 7 and the gate insulator layer 3, so as to form a bit line contact window.

A vacuum deposition and a normal photolithography technique are used to form a bit line 27 which is made of Al, for example.

Thereafter, known techniques are used to form an underlayer interconnection for reducing the resistance of the word lines 4₁ and 4₂, to form other interconnections, and to form bonding pads, passivation layers and the like to complete the semiconductor memory device.

In the semiconductor memory device which is produced in the above described manner, the polysilicon layers 15₁, 15₂ and 15₃ function as the storage electrode. A large part of these polysilicon layers 15₁, 15₂ and 15₃ is supported by the side walls 22 which are made of polysilicon and form a conductive support part. Hence, the strength of the storage electrode (first electrode structure) is improved and there is no need to provide a thick support part at the core as in the case of the conventional fin type semiconductor memory device.

In this embodiment, only one side of each side wall 22 is removed. However, it is also possible to remove other sides of the side wall 22. For example, in a case where it is difficult to fill the opposed electrode 25 between the etching protection layer 13 and the polysilicon layers 15₁, 15₂ and 15₃, it is effective to remove the confronting sides of the side wall 22. Even in this case, the decrease in the strength of the storage electrode is suppressed to a negligible extent. In addition, by removing a portion of the side wall 22 at the bit line contact portion, it is possible to increase the alignment margin when forming the bit line contact window and also increase the etching margin.

In this embodiment, the storage electrode has three fins. However, the number of fins of the storage electrode is not limited to three, and two or four or more fins may be provided.

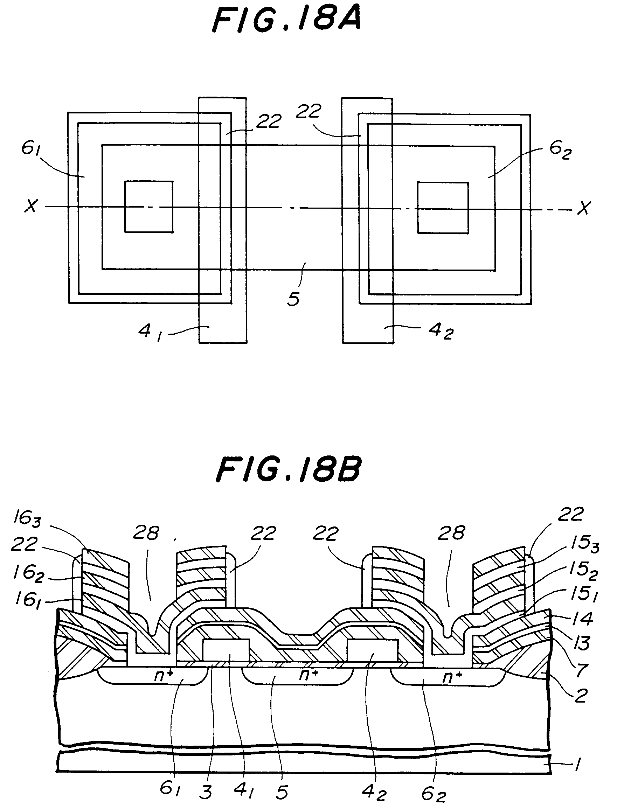

Next a description will be given of a second embodiment of the semiconductor memory device according to the present invention, by referring to FIGS.18 through 20. This embodiment of the semiconductor memory device is produced by a second embodiment of a method of producing the semiconductor memory device according to the present invention.

In FIGS.18 through 20, FIG.jA shows a plan view of an essential part of the semiconductor memory device and FIG.jB shows a cross section along a line X-X in FIG.jA, where j = 18 to 20. Furthermore, in FIGS.18 through 20, those parts which are essentially the same as those corresponding parts in FIGS.12 through 17 are designated by the same reference numerals, and a description thereof will be omitted. FIGS.18 through 20 only show essential production steps of the second embodiment.

In this embodiment, the production steps described in conjunction with FIGS.12 through 14 are carried out to form the side walls 22 similarly as in the case of the first embodiment. The production steps which follow after the formation of the side walls 22 will now be described with reference to FIGS.18 through 20.

In FIGS.18A and 18B, a resist process of a normal photolithography technique and a RIE using a CCl₄ system etching gas, for example, are carried out to form openings 28 at centers of the storage electrode patterns. Each opening 28 extends from the top surface of the SiO₂ layer 16₃ to the top surface of the SiO₂ layer 16₁.

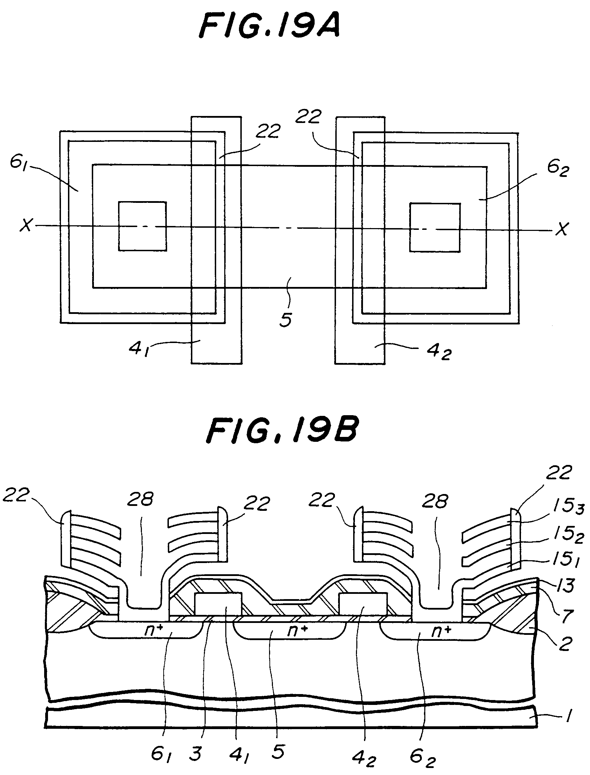

As shown in FIGS.19A and 19B, the photoresist layer which is formed when forming the openings 28 is removed before the structure shown in FIGS.18A and 18B is submerged into a hydrofluoric acid etchant so as to remove the SiO₂ layers 16₃, 16₂ and 16₁. The hydrofluoric acid of course permeates through the openings 28.

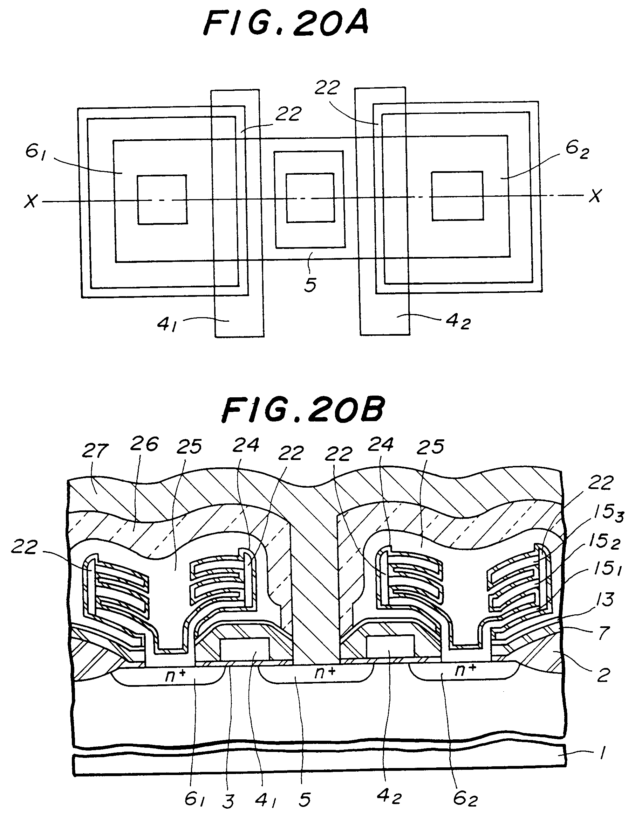

Next, as shown in FIGS.20A and 20B, a thermal oxidation is carried out to form a dielectric layer 24 which is made of SiO₂ on exposed portions of each of the polysilicon layers 15₃, 15₂ and 15₁ and the side walls 22.

Then, opposed electrode (cell plate) 25 which is made of polysilicon and has a thickness of 5000 Å, for example, is formed by a CVD.

A resist process of a normal photolithography technique and a RIE using CCl₄+O₂ as an etching gas, for example, are carried out to pattern the opposed electrode 25.

An interlayer insulator 26 which is made of PSG and has a thickness of 1 µm is formed by a CVD.

A normal photolithography technique is used to selectively etch the interlayer insulator 26, the etching protection layer 13, the interlayer insulator 7 and the gate insulator film 3, so as to form a bit line contact window.

A vacuum deposition and a normal photolithography technique are used to form a bit line 27 which is made of Al, for example.

Thereafter, known techniques are used to form an underlayer for reducing the resistance of the word lines 4₁ and 4₂, other interconnections, bonding pads, a passivation layer and the like to complete the semiconductor memory device.

In the semiconductor memory device which is produced in the above described manner, the entire periphery of the polysilicon layers 15₁, 15₂ and 15₃ which function as the storage electrode is supported by the side wall 22 which is made of polysilicon and form a support part. Hence, the strength of the storage electrode is improved compared to the semiconductor memory device described in conjunction with FIGS.12 through 17.

The opening 28 need not necessarily have to be located at a center part of the region which is surrounded by the side walls 22. For example, the opening 28 may be located in a vicinity of a corner part of the region which is surrounded by the side walls 22.

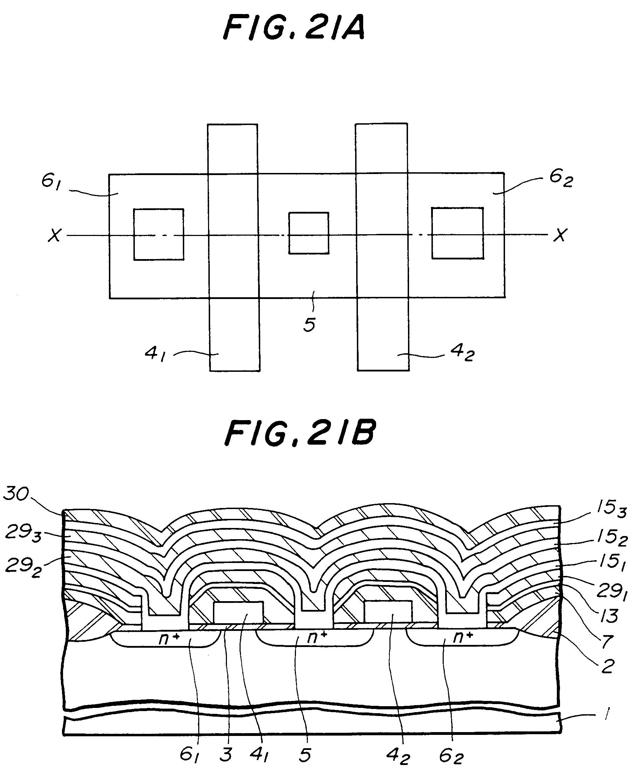

Next, a description will be given of third embodiment of the semiconductor memory device according to the present invention, by referring to FIGS.21 through 26. This embodiment of the semiconductor memory device is produced by a third embodiment of a method of producing the semiconductor memory device according to the present invention.

In FIGS.21 through 26, FIG.kA shows a plan view of an essential part of the semiconductor memory device and FIG.kB shows a cross section along a line X-X in FIG.kA, where k = 21 to 26. Furthermore, in FIGS.21 through 26, those parts which are essentially the same as those corresponding parts in FIGS.12 through 17 are designated by the same reference numerals, and a description thereof will be omitted. FIGS.21 through 26 only show essential production steps of the third embodiment.

In FIGS.21A and 21B, known techniques are used to successively form on a p-type Si semiconductor substrate 1 a field insulator layer 2, a gate insulator film 3, gate electrodes (word lines) 4₁ and 4₂ made of polysilicon, an n⁺-type source region 5, and n⁺-type drain regions 6₁ and 6₂.

An interlayer insulator 7 which is made of SiO₂ and has a thickness of 3000 Å, for example, and an etching protection layer 13 which is made of Si₃N₄ and has a thickness of 500 Å, for example, are successively formed by CVDs. The interlayer insulator 7 may be made of Si₃N₄.

A spacer layer 29₁ which is made of carbon (C) and has a thickness of 2000 Å, for example, is formed by a sputtering process.

A resist process of a normal photolithography technique and a RIE using a CF₄ system etching gas, for example, are used to selectively etch the spacer layer 29₁, the etching protection layer 13, the interlayer insulator 7, the gate insulator film 3 and the like. As a result, a bit line contact window is formed above the source region 5 and a storage electrode contact windows are respectively formed above the drain regions 6₁ and 6₂.

A polysilicon layer 15₁ having a thickness of 1000 Å, a spacer layer 29₂ which is made of C and has a thickness of 2000 Å, a polysilicon layer 15₂ having a thickness of 1000 Å, a spacer layer 29₃ which is made of C and has a thickness of 2000 Å, a polysilicon layer 15₃ having a thickness of 1000 Å, and a SiO₂ layer 30 having a thickness of 2000 Å are successively formed by an appropriate one of CVD and sputtering process. The CVD is used to form the polysilicon and SiO₂ layers. On the other hand, the sputtering process is used to form the spacer layers.

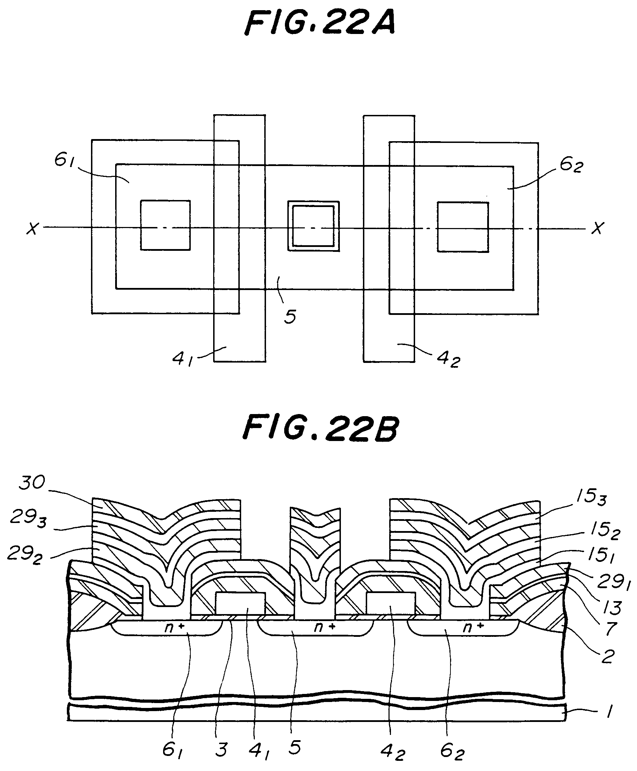

As shown in FIGS.22A and 22B, a RIE using CF₄+O₂ as an etching gas, for example, is carried out to pattern the SiO₂ layer 30, the polysilicon layer 15₃, the spacer layer 29₃, the polysilicon layer 15₂, the spacer layer 29₂ and the polysilicon layer 15₁ by an anisotropic etching. As a result, a bit line contact part pattern and a storage electrode pattern are formed.

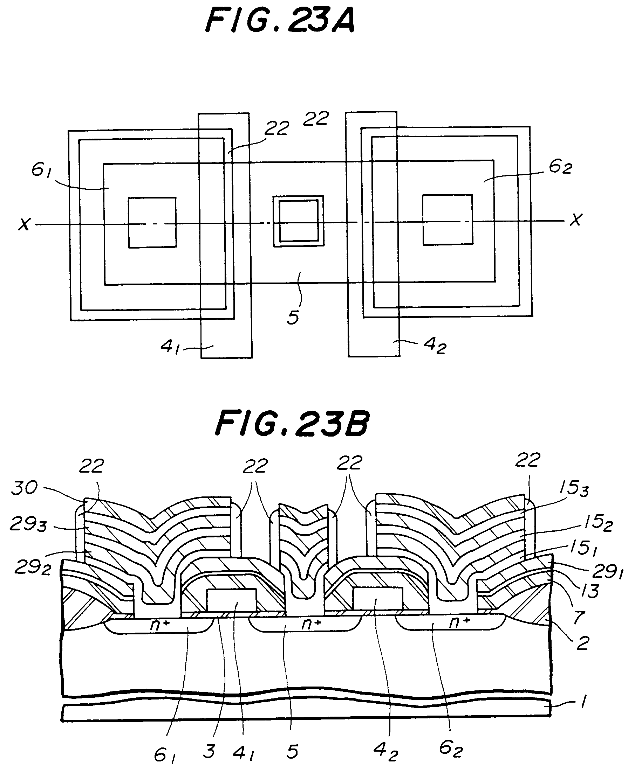

Next, as shown in FIGS.23A and 23B, a CVD is carried out to form a polysilicon layer which has a thickness of 2000 Å, for example, on the entire top surface of the structure shown in FIGS.22A and 22B. A RIE using a CCl₄ system etching gas, for example, is carried out to subject this polysilicon layer to an anisotropic etching. As a result, a side wall 22 which is made of polysilicon is formed at the sides of the plurality of layers of the bit line contact part pattern and the storage electrode pattern, to form a stacked connection structure for the bit line and the first electrode structure. The side wall 22 supports the polysilicon layers 15₁, 15₂ and 15₃ and the spacer layers 29₂ and 29₃ in common, and also functions as a conductive connector.

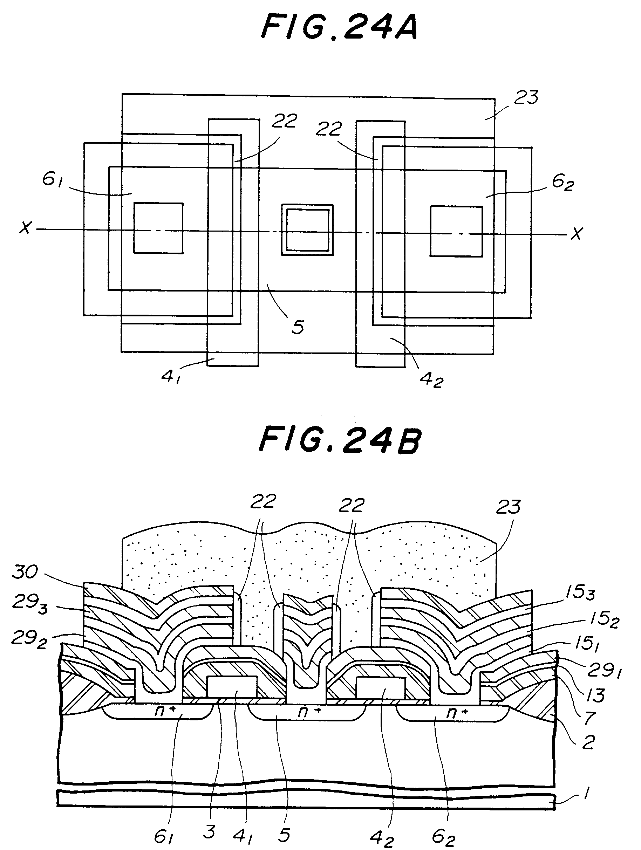

In FIGS.24A and 24B, a resist process of a normal photolithography technique is used to form a photoresist layer 23 which covers a large portion of the side walls 22.

A RIE using CF₄ as an etching gas is carried out to remove exposed portions of the side walls 22 by an isotropic etching.

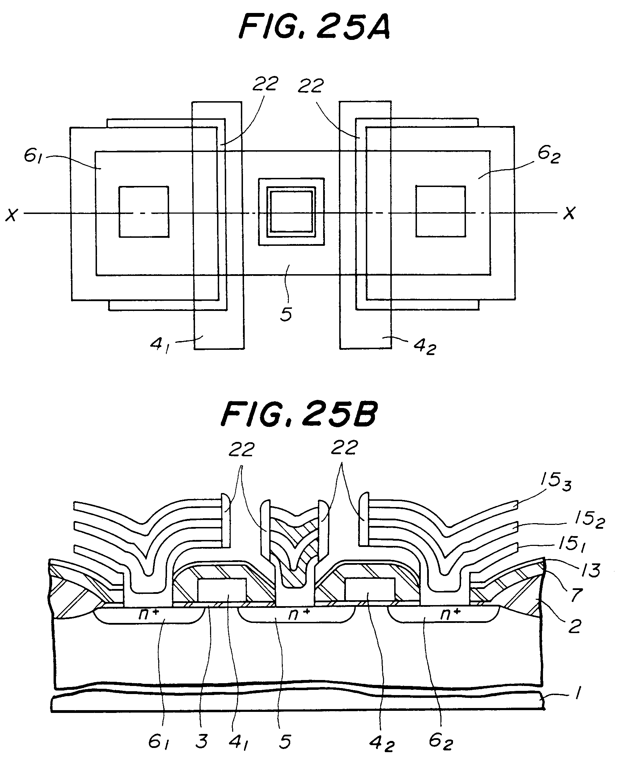

Then, as shown in FIGS.25A and 25B, the photoresist layer 23 is removed, and the structure is submerged into a hydrofluoric acid etchant to remove the SiO₂ layer 30.

The spacer layers 29₃, 29₂ and 29₁ are removed within oxygen plasma. This removal of the spacer layers 29₃, 29₂ and 29₁ is carried out satisfactorily compared to the case described above where SiO₂ is used for the spacers. The spacer layers 29₁, 29₂ and 29₃ remain at the bit line contact part (stacked connection structure) because the peripheral parts of the spacer layers 29₁, 29₂ and 29₃ are completely covered by the side walls 22.

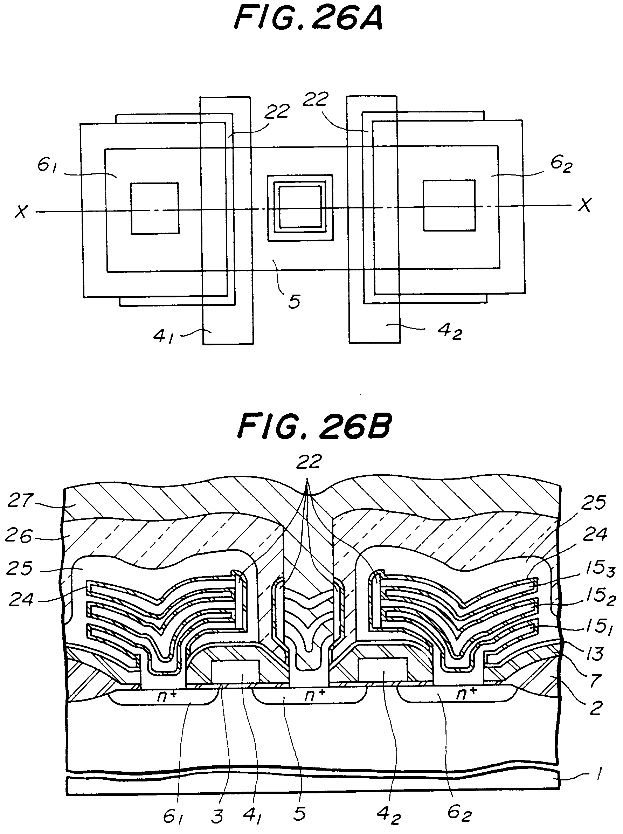

Next, as shown in FIGS.26A and 26B, a dielectric layer 24 which is made of SiO₂ is formed on exposed portions of the polysilicon layers 15₁, 15₂ and 15₃ and the side walls 22 by a thermal oxidation.

A CVD is carried out to form an opposed electrode (cell plate) 25 which is made of polysilicon and has a thickness of 5000 Å, for example.

A resist process of a normal photolithography technique and a RIE using CCl₃+O₂ as an etching gas are carried out to pattern the opposed electrode 25.

An interlayer insulator 26 which is made of PSG and has a thickness of 1 µm, for example, is formed by a CVD.

A normal photolithography technique is used to selectively etch the interlayer insulator 26 and the dielectric layer 24 which is formed on the polysilicon layer 15₃ at the bit line contact part, so as to form a bit line contact window. The bit line contact part exists under the bit line contact window. For this reason, compared to the other embodiments, the aspect ratio of the bit line contact window in this embodiment is small. Consequently, it is possible to prevent the bit line from breaking. In addition, since the spacer layer made of C exists at the bit line contact part, the contact resistance of the bit line is reduced.

A vacuum deposition and a normal photolithography technique are used to form a bit line 27 which is made of Al, for example.

Thereafter, known techniques are used to form an underlayer for reducing the resistance of the word lines, other interconnections, bonding pads, a passivation layer and the like.

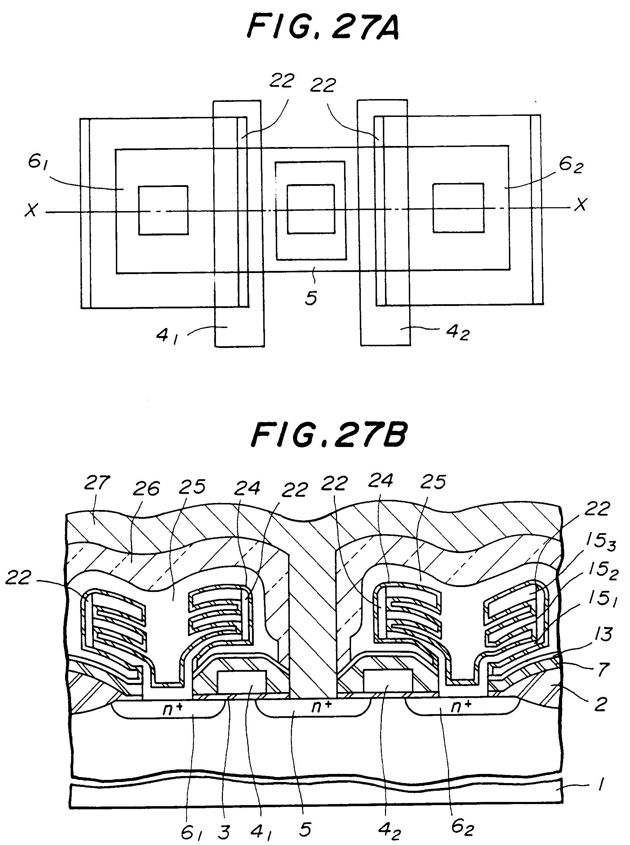

Next, a description will be given of a fourth embodiment of the semiconductor memory device according to the present invention, by referring to FIGS.27A and 27B. FIG.27A shows a plan view of an essential part of the semiconductor memory device and FIG.27B shows a cross section along a line X-X in FIG.27A. Furthermore, in FIGS.27A and 27B, those parts which are essentially the same as those corresponding parts in FIGS.12 through 17 are designated by the same reference numerals, and a description thereof will be omitted.

In this embodiment, the side walls 22 are only provided on two mutually confronting sides as shown in FIG.27A. In addition, the top part of the side wall 22 is rounded and the thickness of the polysilicon layer 15₃ is greater than those of the polysilicon layers 15₂ and 15₁ to improve the mechanical strength. Therefore, it is possible to positively prevent the polysilicon layer 15₃ from breaking off from the side wall 22.

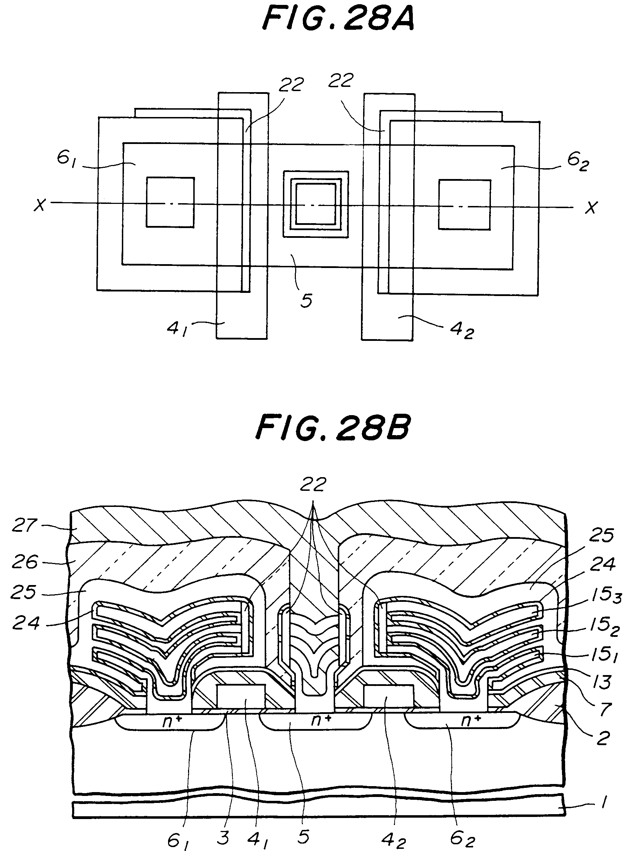

Next, a description will be given of a fifth embodiment of the semiconductor memory device according to the present invention, by referring to FIGS.28A and 28B. FIG.28A shows a plan view of an essential part of the semiconductor memory device and FIG.28B shows a cross section along a line X-X in FIG.28A. Furthermore, in FIGS.28A and 28B, those parts which are essentially the same as those corresponding parts in FIGS.12 through 17 are designated by the same reference numerals, and a description thereof will be omitted.

In this embodiment, the side walls 22 are only provided on two mutually adjacent sides as shown in FIG.28A. In addition, the top part of the side wall 22 is rounded and the thickness of the polysilicon layer 15₃ is greater than those of the polysilicon layers 15₂ and 15₁ to improve the mechanical strength. Therefore, it is possible to positively prevent the polysilicon layer 15₃ from breaking off from the side wall 22.

## Claims

1. A semiconductor memory device including:
a transfer transistor having first and second active regions (6₂,5) constituting respectively source and drain regions of the transistor, which regions are formed in a substrate (1) of the device at a main surface of the substrate;
an insulator layer (2,3,7) formed on the said main surface;
a first conductive layer (15₁) contacting one of the said active regions (6₂), so as to be electrically connected therewith, through a contact hole formed in the said insulator layer (2,3,7), and extending outwardly beyond the periphery of the contact hole so as to overlap the said insulator layer (2,3,7) adjacent to the hole;
at least one further conductive layer (15₂,15₃) located above the said first conductive layer (15₁), and extending generally parallel thereto, to form a stack in which the conductive layers are spaced apart one from the next and connected electrically together to form a first electrode structure of a charge storage capacitor of the device; and
conductive material (25) provided around the said stack, and within the spaces between the adjacent conductive layers thereof, to form a second electrode structure of the charge storage capacitor, which second electrode structure is separated from the said first electrode structure by a dielectric covering layer (24) on the first electrode structure;
characterised by a side wall structure (22) made of conductive material and formed alongside the said stack so as to be connected physically to mutually-corresponding respective outer edge regions, remote from the said contact hole, of the conductive layers (15), so that the said conductive layers (15) together with the said side wall structure (22) constitute the said first electrode structure.

2. A semiconductor memory device as claimed in claim 1, wherein the said side wall structure (22) includes a plurality of side wall portions each made of conductive material and formed alongside the stack.

3. A semiconductor memory device as claimed in claim 1 or 2, wherein the said side wall structure (22) has a rounded top surface which meets with an upper main face of an uppermost one (15₃) of the said further conductive layers (15₂, 15₃) at substantially the level of that upper main face.

4. A semiconductor memory device as claimed in claim 3, wherein the said uppermost one (15₃) of the said further conductive layers (15) is greater in thickness than the other further conductive layers (15₂).

5. A semiconductor memory device as claimed in any one of claims 1 to 4, wherein the said first conductive layer (15₁) occupies a generally rectangular area above the said substrate (1), and the said side wall structure (22) is formed alongside at least two mutually adjacent sides of the generally rectangular area.

6. A semiconductor memory device as claimed in any one of claims 1 to 4, wherein the said first conductive layer (15₁) occupies a generally rectangular area above the said substrate (1), and the said side wall structure (22) is formed alongside at least two mutually opposing sides of the generally rectangular area.

7. A semiconductor memory device as claimed in any one of claims 1 to 4, wherein the said first conductive layer (15₁) occupies a generally rectangular area above the said substrate (1), and the said side wall structure (22) is formed alongside all four sides of the generally rectangular area.

8. A semiconductor memory device as claimed in claim 7, wherein the or each further conductive layer (15₂, 15₃) extends from the side wall structure (22) as far as a central portion of the generally rectangular area but does not extend above that central portion of the generally rectangular area.

9. A semiconductor memory device as claimed in any one of claims 1 to 8, wherein there are provided a first interlayer insulator (26) covering the said second electrode structure (25) and having a contact opening above the other active region (5) of the said transfer transistor, a bit line (27) which is formed on the said first interlayer insulator (25), and a stacked connection structure formed in the said contact opening for electrically connecting the said bit line to the said other active region of the said transfer transistor, the said stacked conductor structure including a further stack of alternate conductive and spacing layers (15₁-15₃, 29₁-29₃) and also including a further side wall structure (22) formed alongside the said further stack so as to be connected physically to mutually-corresponding respective outer edge regions of the conductive layers of the said further stack, so that the said conductive layers (15₁-15₃) of the further stack are connected electrically together.

10. A semiconductor memory device as claimed in claim 9, further including a word line (4₂) formed, between the said source and drain regions (6₂; 5) of the transfer transistor, on a gate insulator film (3) of the said insulator layer (2, 3), and a second interlayer insulator (7) which covers the word line, the said first conductive layer (15₁) having a portion which overlaps the said word line.

11. A semiconductor memory device as claimed in claim 9 or 10, wherein the top surface of the said stacked connection structure is at approximately the same level as the upper main face of the uppermost further conductive layer (15₃) in the said first electrode structure.

12. A semiconductor memory device as claimed in claim 9, 10 or 11, wherein the said spacing layers (29₁-29₃) are made of a conductive material selected from a group including carbon.

13. A method of producing a semiconductor device including a transfer transistor having first and second active regions (6₂,5) constituting respectively source and drain regions of the transistor, which regions are formed in a substrate (1) of the device at a main surface of the substrate, and also including a charge storage capacitor having a first electrode structure connected with one of the said active regions (6₂) and a second electrode structure (25) separated from the said first electrode structure by a dielectric covering layer (24) on the first electrode structure, which method includes the steps of:
providing on the said main surface an insulator layer (2,3,7) formed with a contact hole through which a part of the said one active region (6₂) is exposed;
forming on the said insulator layer (2,3,7) and the exposed part of the said one active region (6₂) a stack of alternate conductive and spacing layers (15_{1,2,3}; 16_{1,2,3}, 29_{1,2,3}) such that the lowermost layer (15₁) is a conductive layer, which contacts the said exposed part through the said contact hole and which extends outwardly beyond the periphery of that hole so as to overlap the said insulator layer (2,3,7) adjacent to the hole, and such that the layers of the stack have mutually-corresponding respective outer edge regions remote from the said contact hole;
forming a side wall structure (22) made of conductive material alongside the said stack so as to be connected physically to the said outer edge regions of the layers of the stack, so that the said conductive layers (15) together with the said side wall structure (22) constitute the said first electrode structure;
removing the said spacing layers (16; 29) from the said stack by an etching process, and then forming the said dielectric covering layer (24) on the exposed surface regions of the said conductive layers (15) and of the said side wall structure (22); and
depositing conductive material (25) over the free surfaces of the said dielectric covering layer (24) to form the said second electrode structure.

14. A method as claimed in claim 13, wherein:
the said insulator layer (2,3,7) is also formed with a further contact hole through which a part of the other active region (5) is exposed, the insulator layer (2,3,7) being provided by forming a gate insulator film (3) on the said substrate above the transfer transistor, forming a word line (4₂) on the gate insulator film (3) between the said source and drain regions (6₂,5), and forming a first interlayer insulator (7) over the word line (4₂), the contact hole of claim 13 and the said further contact hole each passing through the said first interlayer insulator (7) and the gate insulator film (3); and
the alternate conductive and spacing layers (15_{1,2,3}; 29_{1,2,3}) are stacked on the said first interlayer insulator (7) and on the respective exposed parts of the two active regions (6₂,5), such that the lowermost of the stacked layers (15₁) also contacts the said exposed part of the said other active region (5) through the said further contact hole, and then the stacked layers (15_{1,2,3}; 29_{1,2,3}) are patterned to form the said stack of claim 13 and a further stack of the layers, separated from the stack of claim 13, above the said further contact hole;
the method comprising the further steps of:
forming a further side wall structure (22) made of conductive material alongside the said further stack so as to be connected physically to mutually-corresponding respective outer edge regions of the layers of the further stack, so that the said conductive layers (15) of the further stack together with the said further side wall structure (22) constitute a stacked connection structure;
providing on the said second electrode structure a second interlayer insulator (26) formed with a contact opening through which an upper part of the said stacked connection structure is exposed; and
forming conductive material (27) on the said second interlayer insulator and on the exposed upper part of the further stack, so that the conductive material, which serves as a bit line of the device, is connected electrically to the said other active region of the transfer transistor via the said stacked connection structure.

15. A method as claimed in claim 13 or 14, wherein the said spacing layers (29₁-29₃) are made of carbon.

## Patentansprüche

1. Halbleiterspeicheranordnung, welche enthält:
einen Transfertransistor mit einer ersten und zweiten aktiven Zone (6₂, 5), die eine Source- bzw. Drain-Zone des Transistors darstellen, welche Zonen in einem Substrat (1) der Anordnung auf einer Hauptfläche des Substrats gebildet sind;
eine Isolatorschicht (2, 3, 7), die auf der genannten Hauptfläche gebildet ist;
eine erste leitfähige Schicht (15₁), die mit einer der genannten aktiven Zonen (6₂), so daß sie damit elektrisch verbunden ist, durch ein Kontaktloch in Kontakt steht, das in der genannten Isolatorschicht (2, 3, 7) gebildet ist, und nach außen über den Umfang des Kontaktlochs hinaus verläuft, so daß sie die genannte Isolatorschicht (2, 3, 7) benachbart dem Loch überlappt;
zumindest eine weitere leitfähige Schicht (15₂, 15₃), die über der ersten leitfähigen Schicht (15₁) angeordnet ist, und allgemein parallel dazu verläuft, um einen Stapel zu bilden, in dem die leitfähigen Schichten in einem Abstand von der nächsten vorliegen, und elektrisch miteinander verbunden sind, um eine erste Elektrodenstruktur eines Ladungsspeicherkondensators der Anordnung zu bilden; und
leitfähiges Material (25), das rund um den genannten Stapel und innerhalb der Zwischenräume zwischen den benachbarten leitfähigen Schichten davon vorgesehen ist, um eine zweite Elektrodenstruktur des Ladungsspeicherkondensators zu bilden, welche zweite Elektrodenstruktur von der genannten ersten Elektrodenstruktur durch eine dielektrische Deckschicht (24) auf der ersten Elektrodenstruktur getrennt ist;
gekennzeichnet durch eine Seitenwandstruktur (22), die aus leitfähigem Material besteht, und entlang dem genannten Stapel gebildet ist, um physisch mit einander entsprechenden, jeweiligen Außenrandzonen, die vom genannten Kontaktloch entfernt sind, der leitfähigen Schichten (15) verbunden zu sein, so daß die genannten leitfähigen Schichten (15) zusammen mit der genannten Seitenwandstruktur (22) die genannte erste Elektrodenstruktur bilden.

2. Halbleiterspeicheranordnung nach Anspruch 1, bei welcher die genannte Seitenwandstruktur (22) eine Vielzahl von Seitenwandteilen, die jeweils aus leitfähigem Material bestehen, und entlang dem Stapel gebildet sind, enthält.

3. Halbleiterspeicheranordnung nach Anspruch 1 oder 2, bei welcher die genannte Seitenwandstruktur (22) eine abgerundete obere Fläche aufweist, die mit einer oberen Hauptfläche der obersten (15₃) der genannten weiteren leitfähigen Schichten (15₂, 15₃) im wesentlichen auf der Höhe dieser oberen Hauptfläche zusammentrifft.

4. Halbleiterspeicheranordnung nach Anspruch 3, bei welcher die genannte oberste (15₃) der genannten weiteren leitfähigen Schichten (15) eine größere Dicke aufweist als die anderen weiteren leitfähigen Schichten (15₂).

5. Halbleiterspeicheranordnung nach einem der Ansprüche 1 bis 4, bei welcher die genannte erste leitfähige Schicht (15₁) einen allgemein rechteckigen Bereich über dem genannten Substrat (1) einnimmt, und die genannte Seitenwandstruktur (22) entlang zumindest zwei einander benachbarten Seiten des allgemein rechteckigen Bereichs gebildet ist.

6. Halbleiterspeicheranordnung nach einem der Ansprüche 1 bis 4, bei welcher die genannte erste leitfähige Schicht (15₁) einen allgemein rechteckigen Bereich über dem genannten Substrat (1) einnimmt, und die genannte Seitenwandstruktur (22) entlang zumindest zwei einander gegenüberliegenden Seiten des allgemein rechteckigen Bereichs gebildet ist.

7. Halbleiterspeicheranordnung nach einem der Ansprüche 1 bis 4, bei welcher die genannte erste leitfähige Schicht (15₁) einen allgemein rechteckigen Bereich über dem genannten Substrat (1) einnimmt, und die genannte Seitenwandstruktur (22) entlang allen vier Seiten des allgemein rechteckigen Bereichs gebildet ist.

8. Halbleiterspeicheranordnung nach Anspruch 7, bei welcher die oder jede weitere leitfähige Schicht (15₂, 15₃) von der Seitenwandstruktur (22) bis zu einem zentralen Teil des allgemein rechteckigen Bereichs verläuft, jedoch nicht über dem zentralen Teil des allgemein rechteckigen Teils verläuft.

9. Halbleiterspeicheranordnung nach einem der Ansprüche 1 bis 8, bei welcher vorgesehen sind: ein erster Zwischenschichtisolator (26), der die genannte zweite Elektrodenstruktur (25) bedeckt, und eine Kontaktöffnung über der anderen aktiven Zone (5) des genannten Transfertransistors aufweist, eine Bitleitung (27), die auf dem genannten ersten Zwischenschichtisolator (26) gebildet ist, und eine gestapelte Verbindungsstruktur, die in der genannten Kontaktöffnung gebildet ist, zum elektrischen Verbinden der genannten Bitleitung mit der genannten anderen aktiven Zone des genannten Transfertransistors, wobei die genannte gestapelte Leiterstruktur einen weiteren Stapel abwechselnder Leiterund Abstandsschichten (15₁ bis 15₃, 29₁ bis 29₃) enthält, und auch eine weitere Seitenwandstruktur (22) enthält, die entlang dem genannten weiteren Stapel gebildet ist, um physisch mit einander entsprechenden, jeweiligen Außenrandzonen der leitfähigen Schichten des genannten weiteren Stapels verbunden zu sein, so daß die genannten leitfähigen Schichten (15₁ bis 15₃) des weiteren Stapels elektrisch miteinander verbunden sind.

10. Halbleiterspeicheranordnung nach Anspruch 9, welche ferner enthält: eine Wortleitung (4₂), die zwischen der genannten Source- und Drain-Zone (6₂; 5) des Transfertransistors auf einem Gatterisolatorfilm (3) der genannten Isolatorschicht (2, 3) gebildet ist, und einen zweiten Zwischenschicht-Isolator (7), der die Wortleitung bedeckt, wobei die genannte erste leitfähige Schicht (15₁) einen Teil aufweist, der die genannte Wortleitung überlappt.

11. Halbleiterspeicheranordnung nach Anspruch 9 oder 10, bei welcher die obere Fläche der genannten gestapelten Verbindungsstruktur ungefähr auf der gleichen Höhe ist wie die obere Hauptfläche der obersten weiteren leitfähigen Schicht (15₃) in der genannten ersten Elektrodenstruktur.

12. Halbleiterspeicheranordnung nach Anspruch 9, 10 oder 11, bei welcher die genannten Abstandsschichten (29₁ bis 29₃) aus einem leitfähigen Material, das aus einer Kohlenstoff enthaltenden Gruppe ausgewählt ist, bestehen.

13. Verfahren zur Herstellung einer Halbleiteranordnung, die enthält: einen Transfertransistor mit einer ersten und zweiten aktiven Zone (6₂, 5), die eine Source- bzw. Drain-Zone des Transistors darstellen, welche Zonen in einem Substrat (1) der Anordnung auf einer Hauptfläche des Substrats gebildet sind, und auch enthält: einen Ladungsspeicherkondensator, der eine erste Elektrodenstruktur, die mit einer der genannten aktiven Zonen (6₂) verbunden ist, und eine zweite Elektrodenstruktur (25), die von der genannten ersten Elektrodenstruktur durch eine dielektrische Deckschicht (24) auf der ersten Elektrodenstruktur getrennt ist, aufweist, welches Verfahren die Schritte beinhaltet:
Vorsehen einer Isolatorschicht (2, 3, 7), die mit einem Kontaktloch ausgebildet ist, durch das ein Teil der genannten einen aktiven Zone (6₂) freigelegt wird, auf der genannten Hauptfläche;
Bilden eines Stapels abwechselnder Leiter- und Abstandsschichten (15_{1,2,3}; 16_{1,2,3}, 29_{1,2,3}) auf der genannten Isolatorschicht (2, 3, 7) und dem freiliegenden Teil der genannten einen aktiven Zone (6₂), so daß die unterste Schicht (15₁) eine leitfähige Schicht ist, die mit dem genannten freiliegenden Teil durch das genannte Kontaktloch in Kontakt steht, und die nach außen über den Umfang dieses Lochs hinaus verläuft, so daß sie die genannte Isolatorschicht (2, 3, 7) benachbart dem Loch überlappt, und so daß die Schichten des Stapels einander entsprechende, jeweilige Außenrandzonen entfernt vom genannten Kontaktloch aufweisen;
Bilden einer Seitenwandstruktur (22), die aus leitfähigem Material besteht, entlang dem genannten Stapel, um physisch mit den genannten Außenrandzonen der Schichten des Stapels verbunden zu sein, so daß die genannten leitfähigen Schichten (15) zusammen mit der genannten Seitenwandstruktur (22) die genannte erste Elektrodenstruktur bilden;
Entfernen der genannten Abstandsschichten (16; 29) vom genannten Stapel durch ein Ätzverfahren, und anschließendes Bilden der genannten dielektrischen Deckschicht (24) auf den freigelegten Oberflächenzonen der genannten leitfähigen Schichten (15) und der genannten Seitenwandstruktur (22); und
Abscheiden von leitfähigem Material (25) über den freien Flächen der genannten dielektrischen Deckschicht (24), um die genannte zweite Elektrodenstruktur zu bilden. Verfahren nach Anspruch 13, bei welchem:
die genannte Isolatorschicht (2, 3, 7) auch mit einem weiteren Kontaktloch ausgebildet wird, durch das ein Teil der anderen aktiven Zone (5) freigelegt wird, wobei die Isolatorschicht (2, 3, 7) vorgesehen wird, indem ein Gatterisolatorfilm (3) auf dem genannten Substrat über dem Transfertransistor gebildet wird, eine Wortleitung (4₂) auf dem Gatterisolatorfilm (3) zwischen der genannten Source- und Drain-Zone (6₂, 5) gebildet wird, und ein erster Zwischenschichtisolator (7) über der Wortleitung (4₂) gebildet wird, wobei das Kontaktloch von Anspruch 13 und das genannte weitere Kontaktloch jeweils durch den genannten ersten Zwischenschichtisolator (7) und den Gatterisolatorfilm (3) hindurchgehen; und
die abwechselnden Leiter- und Abstandsschichten (15_{1,2,3}; 29_{1,2,3}) auf dem genannten ersten Zwischenschichtisolator (7) und auf den entsprechenden freiliegenden Teilen der beiden aktiven Zonen (6₂, 5) gestapelt werden, so daß die unterste der gestapelten Schichten (15₁) auch mit dem genannten freiliegenden Teil der genannten anderen aktiven Zone (5) durch das genannte weitere Kontaktloch in Kontakt steht, und dann die gestapelten Schichten (15_{1,2,3}; 29_{1,2,3}) gemustert werden, um den genannten Stapel von Anspruch 13 und einen weiteren Stapel der Schichten, der vom Stapel von Anspruch 13 getrennt ist, über dem genannten weiteren Kontaktloch zu bilden;
welches Verfahren ferner die Schritte umfaßt:
Bilden einer weiteren Seitenwandstruktur (22), die aus leitfähigem Material besteht, entlang dem genannten weiteren Stapel, um physisch mit einander entsprechenden, jeweiligen Außenrandzonen der Schichten des weiteren Stapels verbunden zu sein, so daß die genannten leitfähigen Schichten (15) des weiteren Stapels zusammen mit der genannten weiteren Seitenwandstruktur (22) eine gestapelte Verbindungsstruktur bilden;
Vorsehen eines zweiten Zwischenschichtisolators (26), der mit einer Kontaktöffnung ausgebildet wird, durch die ein oberer Teil der genannten gestapelten Verbindungsstruktur freigelegt wird, auf der genannten zweiten Elektrodenstruktur; und
Bilden von leitfähigem Material (27) auf dem genannten zweiten Zwischenschichtisolator und auf dem freiliegenden oberen Teil des weiteren Stapels, so daß das leitfähige Material, das als Bitleitung der Anordnung dient, elektrisch mit der genannten anderen aktiven Zone des Transfertransistors über die genannte gestapelte Verbindungsstruktur verbunden wird.

14. Verfahren nach Anspruch 13 oder 14, bei welchem die genannten Abstandsschichten (29₁ bis 29₃) aus Kohlenstoff bestehen.

## Revendications

1. Dispositif de mémoire à semiconducteur incluant :
un transistor de transfert comportant des première et seconde régions actives (6₂, 5) constituant respectivement des régions de source et de drain du transistor, lesquelles régions sont formées dans un substrat (1) du dispositif au niveau d'une surface principale du substrat ;
une couche isolante (2, 3, 7) formée sur ladite surface principale ;
une première couche conductrice (15₁) entrant en contact avec l'une desdites régions actives (6₂) de manière à être connectée électriquement à elle par l'intermédiaire d'un trou de contact formé dans ladite couche isolante (2, 3, 7) et s'étendant vers l'extérieur au-delà de la périphérie du trou de contact de manière à chevaucher ladite couche isolante (2, 3, 7) adjacente au trou ;
au moins une couche conductrice supplémentaire (15₂, 15₃) située au-dessus de ladite première couche conductrice (15₁) et s'étendant de façon générale parallèlement à celle-ci afin de former un empilement dans lequel les couches conductrices sont espacées de l'une à l'autre et sont connectées électriquement ensemble afin de former une première structure d'électrode d'une capacité de stockage de charge du dispositif ; et
un matériau conducteur (25) prévu autour dudit empilement et à l'intérieur des espaces séparant ses couches conductrices adjacentes afin de former une seconde structure d'électrode de la capacité de stockage de charge, laquelle seconde structure d'électrode est séparée de ladite première structure d'électrode par une couche de recouvrement diélectrique (24) déposée sur la première structure d'électrode,
caractérisé par une structure de paroi latérale (22) réalisée en un matériau conducteur et formée le long dudit empilement de manière à être connectée physiquement à des régions de bord externes respectives se correspondant mutuellement, éloignées dudit trou de contact, des couches conductrices (15) de telle sorte que lesdites couches conductrices (15) ensemble avec ladite structure de paroi latérale (22) constituent ladite structure d'électrode.

2. Dispositif de mémoire à semiconducteur selon la revendication 1, dans lequel ladite structure de paroi latérale (22) inclut une pluralité de parties de paroi latérale dont chacune est réalisée en un matériau conducteur et est formée le long de l'empilement.

3. Dispositif de mémoire à semiconducteur selon la revendication 1 ou 2, dans lequel ladite structure de paroi latérale (22) comporte une surface supérieure arrondie qui rencontre une face principale supérieure de la plus supérieure (15₃) desdites couches conductrices supplémentaires (15₂, 15₃) sensiblement au niveau de cette face principale supérieure.

4. Dispositif de mémoire à semiconducteur selon la revendication 3, dans lequel ladite la plus supérieure (15₃) desdites couches conductrices supplémentaires (15) présente une épaisseur supérieure à celle des autres couches conductrices supplémentaires (15₂).

5. Dispositif de mémoire à semiconducteur selon l'une quelconque des revendications 1 à 4, dans lequel ladite première couche conductrice (15₁) occupe une aire de forme générale rectangulaire au-dessus dudit substrat (1) et ladite structure de paroi latérale (22) est formée le long d'au moins deux côtés mutuellement adjacents de l'aire de forme générale rectangulaire.

6. Dispositif de mémoire à semiconducteur selon l'une quelconque des revendications 1 à 4, dans lequel ladite première couche conductrice (15₁) occupe une aire de forme générale rectangulaire au-dessus dudit substrat (1) et ladite structure de paroi latérale (22) est formée le long d'au moins deux côtés mutuellement opposés de l'aire de forme générale rectangulaire.

7. Dispositif de mémoire à semiconducteur selon l'une quelconque des revendications 1 à 4, dans lequel ladite première couche conductrice (15₁) occupe une aire de forme générale rectangulaire au-dessus dudit substrat (1) et ladite structure de paroi latérale (22) est formée le long de l'ensemble de l'ensemble des quatre côtés de l'aire de forme générale rectangulaire.

8. Dispositif de mémoire à semiconducteur selon la revendication 7, dans lequel la couche conductrice supplémentaire ou chaque couche conductrice supplémentaire (15₂, 15₃) s'étend depuis la structure de paroi latérale (22) jusqu'à aussi loin qu'une partie centrale de l'aire de forme générale rectangulaire mais ne s'étend pas au-delà de cette partie centrale de l'aire de forme générale rectangulaire.

9. Dispositif de mémoire à semiconducteur selon l'une quelconque des revendications 1 à 8, dans lequel sont prévus un premier isolant intercouche (26) qui recouvre ladite seconde structure d'électrode (25) et qui comporte une ouverture de contact au-dessus de l'autre région active (5) dudit transistor de transfert, une ligne de bit (27) qui est formée sur ledit premier isolant intercouche (25) et une structure de connexion empilée formée dans ladite ouverture de contact pour connecter électriquement ladite ligne de bit à ladite autre région active dudit transistor de transfert, ladite structure conductrice empilée incluant un empilement supplémentaire de couches conductrices et d'espacement alternées (15₁ - 15₃, 29₁ - 29₃) et incluant également une structure de paroi latérale supplémentaire (22) formée le long dudit empilement supplémentaire de manière à être connectée physiquement à des régions de bord externes respectifs se correspondant mutuellement des couches conductrices dudit empilement supplémentaire de telle sorte que lesdites couches conductrices (15₁, 15₃) de l'empilement supplémentaire soient connectées électriquement ensemble.

10. Dispositif de mémoire à semiconducteur selon la revendication 9, incluant en outre une ligne de mot (4₂) formée entre lesdites régions de source et de drain (6₂ ; 5) du transistor de transfert, sur un film d'isolation de grille (3) de ladite couche isolante (2, 3), et un second isolant intercouche (7) qui recouvre la ligne de mot, ladite première couche conductrice (15₁) comportant une partie qui chevauche ladite ligne de mot.

11. Dispositif de mémoire à semiconducteur selon la revendication 9 ou 10, dans lequel la surface supérieure de ladite structure de connexion empilée est approximativement au même niveau que la face principale supérieure de la couche conductrice supplémentaire la plus supérieure (15₃) de ladite première structure d'électrode.

12. Dispositif de mémoire à semiconducteur selon la revendication 9, 10 ou 11, dans lequel lesdites couches d'espacement (29₁ - 29₃) sont réalisées en un matériau conducteur choisi parmi un groupe incluant le carbone.

13. Procédé de fabrication d'un dispositif à semiconducteur incluant un transistor de transfert comportant des première et seconde régions actives (6₂, 5) constituant respectivement des régions de source et de drain du transistor, lesquelles régions sont formées dans un substrat (1) du dispositif au niveau d'une surface principale du substrat et incluant également une capacité de stockage de charge comportant une première structure d'électrode connectée à l'une, dite première région citée (6₂), desdites régions actives et une seconde structure d'électrode (25) séparée de ladite première structure d'électrode par une couche de recouvrement diélectrique (24) déposée sur la première structure d'électrode, lequel procédé inclut les étapes de :
production sur ladite surface principale d'une couche isolante (2, 3, 7) formée moyennant un trou de contact au travers duquel une partie de ladite première région citée, (62), des régions actives est mise à nu ;
formation sur ladite couche isolante (2, 3, 7) et sur la partie mise à nu de ladite première région citée, (6₂), des régions actives d'un empilement de couches conductrices et d'espacement alternées (15_{1, 2, 3} ; 16_{1, 2, 3}, 29_{1, 2,} 3) de telle sorte que la couche la plus inférieure (15₁) soit une couche conductrice, laquelle entre en contact avec ladite partie mise à nu par l'intermédiaire dudit trou de contact et s'étend vers l'extérieur au-delà de la périphérie de ce trou de manière à chevaucher ladite couche isolante (2, 3, 7) adjacente au trou et de telle sorte que les couches de l'empilement comportent des régions de bord externes respectives se correspondant mutuellement éloignées dudit trou de contact ;
formation d'une structure de paroi latérale (22) réalisée en un matériau conducteur le long dudit empilement de manière à ce qu'elle soit connectée physiquement auxdites régions de bord externes des couches de l'empilement de telle sorte que lesdites couches conductrices (15) ensemble avec ladite structure de paroi latérale (22) constituent ladite première structure d'électrode ;
enlèvement desdites couches d'espacement (16 ; 29) dudit empilement au moyen d'un procédé de gravure puis formation de ladite couche de recouvrement diélectrique (24) sur les régions de surface mises à nu desdites couches conductrices (15) et de ladite structure de paroi latérale (22) ; et
dépôt de matériau conducteur (25) sur les surfaces libres de ladite couche de recouvrement diélectrique (24) de manière à former ladite seconde structure d'électrode.

14. Procédé selon la revendication 13, dans lequel:
ladite couche isolante (2, 3, 7) est également formée moyennant un autre trou de contact au travers duquel une partie de l'autre région active (5) est mise à nu, la couche isolante (2, 3, 7) étant produite en formant un film d'isolation de grille (3) sur ledit substrat au-dessus du transistor de transfert en formant une ligne de mot (4₂) sur le film d'isolation de grille (3) entre lesdites régions de source et de drain (6₂, 5) et en formant un premier isolant intercouche (7) sur la ligne de mot (4₂), le trou de contact de la revendication 13 et ledit trou de contact supplémentaire passant chacun au travers dudit premier isolant intercouche (7) et du film isolant de grille (3) ; et
les couches conductrices et d'espacement alternées (15_{1, 2, 3} ; 29_{1, 2, 3}) sont empilées sur ledit premier isolant intercouche (7) et sur les parties mises à nu respectives des deux régions actives (6₂, 5) de telle sorte que la plus inférieure des couches empilées (15₁) entre également en contact avec ladite partie mise à nu de ladite autre région active (5) au travers dudit trou de contact supplémentaire puis les couches empilées (15_{1, 2, 3} ; 29_{1, 2, 3}) sont conformées pour former ledit empilement de la revendication 13 et un empilement supplémentaire des couches, séparé de l'empilement de la revendication 13, au-dessus dudit trou de contact supplémentaire ;
le procédé comprenant les étapes supplémentaires de :
formation d'une structure de paroi latérale supplémentaire (22) réalisée en un matériau conducteur le long dudit empilement supplémentaire de manière à ce qu'elle soit connectée physiquement à des régions de bord externes respectives se correspondant mutuellement des couches de l'empilement supplémentaire de telle sorte que lesdites couches conductrices (15) de l'empilement supplémentaire ensemble avec ladite structure de paroi latérale supplémentaire (22) constituent une structure de connexion empilée ;
production sur ladite seconde structure d'électrode d'un second isolant intercouche (26) formé moyennant une ouverture de contact au travers de laquelle une partie supérieure de ladite structure de connexion empilée est mise à nu ; et
formation d'un matériau conducteur (27) sur ledit second isolant intercouche et sur la partie supérieure mise à nu de l'empilement supplémentaire de telle sorte que le matériau conducteur qui joue le rôle de ligne de bit du dispositif soit connecté électriquement à ladite autre région active du transistor de transfert via ladite structure de connexion empilée.

15. Procédé selon la revendication 13 ou 14, dans lequel lesdites couches d'espacement (29₁ - 29₃) sont réalisées en carbone.
